# EUROPÄISCHE PATENTANMELDUNG

(11) **EP 2 466 635 A2**
(43) Veröffentlichungstag der Anmeldung: **20.06.2012**
(21) Anmeldenummer: 11188735.2
(22) Anmeldetag: 11.11.2011
(51) Int. Cl.: H01L 23/049, H01L 23/48

(54) **Halbleiterschaltungsanordnung**

(30) Priorität: 16.12.2010 DE 102010063220
(71) Anmelder: SEMIKRON Elektronik GmbH & Co. KG, 90431 Nürnberg (DE)
(72) Erfinder: Hofmair, Markus, 91154 Roth (DE); Mauer, Peter, 90766 Fürth (DE)

(57) **Zusammenfassung**

Es wird eine Halbleiterschaltungsanordnung (10) mit mindestens einem Schaltungssubstrat (12), das von einem Gehäuse (14) umschlossen ist, und mit einem mit dem Gehäuse (14) kombinierten Druckkörper (16) beschrieben, wobei zur Druckkontaktierung des mindestens einen Schaltungssubstrates (12) in Federschächten (20) Anschlußelemente (18) angeordnet sind. Die Anschlußelemente (18) weisen vorzugsweise einen durch Schraubwindungen (28) gebildeten Federabschnitt (26) auf. Im Druckkörper (16), der beispielsweise auch einen Deckel des Gehäuses (14) bilden kann, ist mindestens ein Ferritkern (34) vorgesehen, welcher vorzugsweise den Schraubwindungen (28) mindestes eines Anschlußelementes (18) zugeordnet ist. Bevorzugt ist es, wenn der Ferritkern (34) als Ringkern ausgebildet ist, der die Schraubwindungen (28) eines jeweiligen Gate- Anschlußelementes (36) und eines zu diesem eng benachbarten Emitter- Anschlußelementes (38) umschließt.

## Beschreibung

Die Erfindung betrifft eine Halbleiterschaltungsanordnung mit mindestens einem Schaltungssubstrat, das von einem Gehäuse umschlossen ist, und mit einem mit dem Gehäuse kombinierten Druckkörper, wobei zur Druckkontaktierung des mindestens einen Schaltungssubstrates in Federschächten Anschlußelemente angeordnet sind, die einen durch Schraubwindungen gebildeten Federabschnitt aufweisen.

Eine derartige Halbleiterschaltungsanordnung ist beispielsweise aus der DE 10 2004 025 609 A1 bekannt. Bei dieser bekannten Halbleiterschaltungsanordnung sind insbesondere Hilfsanschlußelemente mit einem durch Schraubwindungen gebildeten Federabschnitt ausgebildet. Die Hilfsanschlußelemente werden mit Druck beaufschlagt, um zwischen Leiterbahnen des Schaltungssubstrates und zugehörigen Leiterbahnen einer Leiterplatte eine sichere elektrische Druckkontaktierung herzustellen.

Die DE 10 2006 006 421 A1 offenbart eine Halbleiterschaltungsanordnung der eingangs genannten Art mit Last- Anschlußelementen und mit Hilfs-Anschlußelementen, wobei die Hilfs- Anschlußelemente auch Steueranschlüsse, wie beispielsweise Gate- Anschlüsse von IGBT (insolated gate bipolar transistor) einschließen. Auch bei dieser bekannten Halbleiterschaltungsanordnung sind die Anschlußelemente mit einem durch Schraubwindungen gebildeten Federabschnitt ausgebildet.

Aus der WO 2004/102806 A1 ist eine Halbleiterschaltungsanordnung bekannt, wobei eine Ansteuereinheit mindestens ein Ansteuersignal erzeugt, mindestens zwei durch das Ansteuersignal synchron schaltbare Leistungshalbleiterelemente mit je einem ersten und zweiten Hauptanschluss jeweils untereinander elektrisch parallel geschaltet sind, jedes Leistungshalbleiterelement eine erste und eine zweite elektrisch leitende Verbindung zum Anschluß an die Ansteuereinheit aufweist, und in jeder ersten elektrisch leitenden Verbindung eine erste Induktivität und in jeder zweiten elektrisch leitenden Verbindung eine zweite Induktivität vorgesehen ist. Für jedes Leistungshalbleiterelement ist je eine Gleichtaktunterdrückungsdrossel vorgesehen, wobei jeweils eine erste Wicklung der Gleichtaktunterdrückungsdrossel die erste Induktivität und eine zweite Wicklung der Gleichtaktunterdrückungsdrossel die zweite Induktivität bildet. Die Gleichtaktunterdrückungsdrosseln für die Leistungshalbleiterelemente stellen kostenintensive Bauteile dar.

Der Erfindung liegt die Aufgabe zugrunde, eine Halbleiterschaltungsanordnung der eingangs genannten Art zu schaffen, wobei auf solche kostenintensive, zusätzliche Bauteile ohne Funktionseinschränkung verzichtet werden kann.

Diese Aufgabe wird erfindungsgemäß durch die Merkmale des Anspruches 1, d.h. dadurch gelöst, dass im Druckkörper mindestens ein Ferritkern vorgesehen ist, der mindestes einem Anschlußelement zugeordnet ist.

Bei dem Druckkörper kann es sich um ein Bauteil handeln, das in einem Gehäuse der Halbleiterschaltungsanordnung zur Druckausübung vorgesehen ist. Desgleichen ist es beispielsweise möglich, dass der Druckkörper einen Deckel bildet, mittels welchem das Gehäuse verschlossen wird.

Das mindestens eine Anschlußelement kann einen stiftförmigen Kontaktabschnitt, einen daran anschließenden Federabschnitt mit Schraubwindungen und einen daran anschließenden Bügelabschnitt aufweisen.

Der mindestens eine Ferritkern kann jedem beliebigen Abschnitt mindestens eines Anschlußelementes zugeordnet sein. Bei dem besagten Abschnitt kann es sich um den erwähnten Stiftabschnitt und/oder um den Bügelabschnitt handeln. Vorteilhaft kann es jedoch sein, wenn der Ferritkern den Schraubwindungen mindestens eines Anschlußelementes zugeordnet ist.

Nachdem bei erfindungsgemäßen Halbleiterschaltungsanordnungen die Gate- Anschlußelemente und die Emitter- Anschlußelemente von IGBT-Chipbauelementen üblicherweise relativ eng benachbart vorgesehen sind, hat es sich erfindungsgemäß als besonders vorteilhaft erwiesen, wenn in den Druckkörper mindestes ein Ferritkern eingespritzt ist, der den Schraubwindungen des jeweiligen Gate- Anschlußelementes und des zu diesem eng benachbarten Emitter- Anschlußelementes gemeinsam zugeordnet ist.

Eine Halbleiterschaltungsanordnung mit einem Gehäuse für ein Schaltungssubstrat, einem Druckkörper und mit Anschlußeinrichtungen für das Schaltungssubstrat ist in der älteren Patentanmeldung DE 10 2010 035 980 beschrieben, wobei die jeweilige Anschlußeinrichtung einen dem Gehäuse zugeordneten ersten Federschachtkörper und einen dem Druckkörper zugeordneten zweiten Federschachtkörper aufweist, die gemeinsam einen Federschacht bilden, in dem eine Kontaktfeder unverlierbar und gegen Verdrehung gesichert vorgesehen ist. Dabei können mindestens zwei Federschächte mit den zugehörigen Kontaktfedern einteilig zu einem Federschachtblock kombiniert sein, wenn die Kontaktfedern eng benachbart nebeneinander vorgesehen sind.

Erfindungsgemäß ist es vorteilhaft, wenn der Ferritkern die Schaubwindungen eines Gate- und Emitter- Anschluβelementes, die - wie bereits ausgeführt worden ist - nebeneinander eng benachbart angeordnet sind, als Ringkern umschließt. Dabei kann der Ringkern einen kreisrunden, einen ovalen oder einen beliebig anders geformten Ringquerschnitt besitzen.

Durch das Umschließen des jeweiligen Gate- und der Emitter-Anschlußelementes mittels eines zugehörigen, als Ringkern ausgebildeten Ferritkernes, kann die gleiche elektrische Wirkung erzielt werden, wie mit Induktivitäten bzw. Gleichtaktunterdrückungsdrosseln, wie sie weiter oben in Verbindung mit der WO 2004/102806 A1 beschrieben worden sind. Erfindungsgemäß ist die Anzahl der Schraubwindungen des Federabschnittes des jeweiligen Anschlußelementes zwar begrenzt, eine Funktionseinschränkung kann jedoch durch geeignete Auswahl und/oder Dimensionierung des jeweiligen Ferritkernes ausgeglichen, d.h. die Wirkung über die Auswahl der Ferritkerne beeinflusst werden.

Weitere Einzelheiten, Merkmale und Vorteile ergeben sich aus der nachfolgenden Beschreibung eines in der Zeichnung dargestellten Ausführungsbeispieles der erfindungsgemäßen Halbleiterschaltungsanordnung.

Es zeigen:

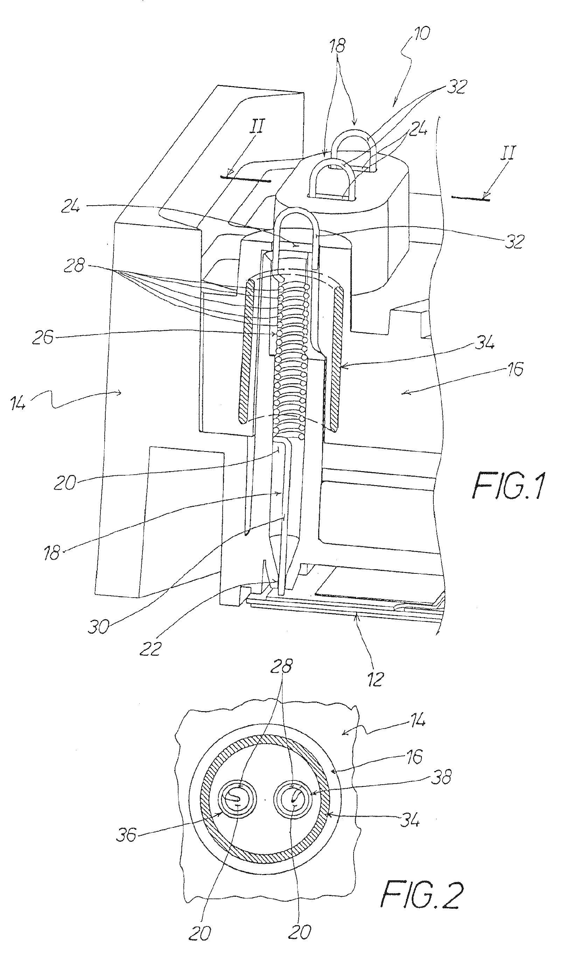

Figur 1 abschnittweise in einer perspektivischen Schnittansicht eine Ausführungsform der Halbleiterschaltungsanordnung 10 mit mindestens einem Schaltungssubstrat 12, das von einem Gehäuse 14 umschlossen ist. Im Gehäuse 14 ist ein Druckkörper 16 vorgesehen, der zur Druckkontaktierung von Anschlußelementen 18 mit dem Schaltungssubstrat 12 vorgesehen ist. Zur Druckkontaktierung des mindestens einen Schaltungssubstrates 12 sind für die Anschlußelemente 18 jeweils Federschächte 20 vorgesehen. Jeder Federschacht 20 ist an seinem dem Schaltungssubstrat 12 zugewandten Ende mit einem Durchgangsloch 22 und an seinem davon abgewandten Ende mit einem Durchgangsschlitz 24 ausgebildet.

Das jeweilige Anschlußelement 18 weist einen Federabschnitt 26 auf, der durch Schraubwindungen 28 gebildet ist. An den Federabschnitt 26 schließt auf der einen Seite ein Stiftabschnitt 30 materialeinstückig an, der sich geführt durch das Durchgangsloch 22 hindurch erstreckt. An den Federabschnitt 26 schließt auf der anderen Seite materialeinstückig ein Bügelabschnitt 32 an, der sich durch den zugehörigen Durchgangsschlitz 24 hindurch erstreckt.

In den Druckkörper 16 ist mindestens ein Ferritkern 34 eingespritzt, der einem Gate- Anschlußelement 36 und einem zu diesem eng benachbarten Emitter- Anschlußelement 38 (siehe auch Figur 2) zugeordnet ist. Wie aus Figur 1 ersichtlich ist, umschließt der als Ringkern ausgebildete Ferritkern 34 die Schraubwindungen 28 des Gate- und des Emitter- Anschlußelementes 36 und 38. Selbstverständlich wäre es auch möglich, dass der Ferritkern 34 beispielsweise den Stiftabschnitt 30 des Gate-Anschlußelementes 36 und des zu diesem eng benachbarten Emitter-Anschußelementes 38 umschließt.

### Bezugsziffernliste:

- 10: Halbleiterschaltungsanordnung
- 12: Schaltungssubstrat (von 10)
- 14: Gehäuse (von 10 für 12)
- 16: Druckkörper (von 10 in 14 für 18)
- 18: Anschlußelemente (von 10 für 12)
- 20: Federschacht (für18)
- 22: Durchgangsloch (von 20 für 30)
- 24: Durchgangsschlitz (von 20 für 32)
- 26: Federabschnitt (von 18)
- 28: Schraubwindungen (von 26)
- 30: Stiftabschnitt (von 18)
- 32: Bügelabschnitt (von 18)
- 34: Ferritkern (von 10 in 16 bei 26)
- 36: Gate- Anschlußelement (von 10)
- 38: Emitter- Anschlußelement (von 10)

## Patentansprüche

1. Halbleiterschaltungsanordnung mit mindestens einem Schaltungssubstrat (12), das von einem Gehäuse (14) umschlossen ist, und mit einem mit dem Gehäuse (14) kombinierten Druckkörper (16), wobei zur Druckkontaktierung des mindestens einen Schaltungssubstrates (12) in Federschächten (20) Anschlußelemente (18) angeordnet sind,
**dadurch gekennzeichnet,**
**dass** im Druckkörper (16) ein mindestens ein Ferritkern (34) vorgesehen ist, der mindestes einem Anschlußelement (18) zugeordnet ist.

2. Halbleiterschaltungsanordnung nach Anspruch 1,
**dadurch gekennzeichnet,**
**dass** das mindestens eine Anschlußelement (18) einen durch Schraubwindungen (28) gebildeten Federabschnitt (26) aufweist, an den sich an der einen Seite ein Stiftabschnitt (30) und an den sich an der davon abgewandten Seite ein Bügelabschnitt (32) anschließt, wobei der Ferritkern (30) dem Federabschnitt (26) und/oder dem Stiftabschnitt (30) und/oder dem Bügelabschnitt (32) zugeordnet ist.

3. Halbleiterschaltungsanordnung nach Anspruch 2,
**dadurch gekennzeichnet,**
**dass** in den Druckkörper (16) mindestens ein Ferritkern (34) eingespritzt ist, welcher den Schraubwindungen (28) eines zugehörigen Gate-Anschlußelementes (36) und eines zu diesem eng benachbarten Emitter-Anschlußelementes (38) zugeordnet ist.

4. Halbleiterschaltungsanordnung nach Anspruch 3,
**dadurch gekennzeichnet,**
**dass** der Ferritkern (34) die Schraubwindungen (28) des jeweiligen Gate-Anschlußelementes (36) und des zu diesem eng benachbarten Emitter-Anschlußelementes (38) als Ringkern umschließt.
